# EUROPEAN PATENT APPLICATION

(11) **EP 2 315 204 A1**
(43) Date of publication of application: **27.04.2011**
(21) Application number: 09305997.0
(22) Date of filing: 21.10.2009
(51) Int. Cl.: G11B 7/24

(54) **Optical recording medium and method and apparatus for reading from such medium**

(71) Applicant: Thomson Licensing, 92130 Issy-les-Moulineaux (FR)
(72) Inventor: Khrushchev, Sergey, 78089, Unterkirnach (DE); Bammert, Michael, 78739, Hardt (DE); Ballweg, Christof, 4242, Laufen (CH)
(74) Representative: Schmidt-Uhlig, Thomas

(57) **Abstract**

High density optical recording medium and method and apparatus for reading from such medium

A high density optical recording medium (1) is proposed, more specifically an optical recording medium (1) with a charge carrier generating layer, as well as a method and an apparatus (2) for reading from such an optical recording medium (1).

The charge carrier generating layer (12) of the optical recording medium (1) is sandwiched between a first conductive layer (16) and a second conductive layer (17). Marks (15) are recorded in the first conductive layer (16) or in the second conductive layer (17).

## Description

The present invention relates to an optical recording medium, more specifically to an optical recording medium with a charge carrier generating layer, i.e. a layer capable of generating free charge carriers under illumination. The invention further relates to a method and an apparatus for reading from such an optical recording medium.

Optical data storage is generally limited by the optical resolution of the read/write-system. Straightforward methods of increasing the optical resolution include using a shorter wavelength and a larger numerical aperture NA, at the costs of lens complexity. As an alternative a so-called super-resolution near field structure (Super-RENS) can be placed directly above a data layer of the optical recording medium, which significantly reduces the effective size of a light spot used for reading from and/or writing to the optical recording medium. Optical recording media with such a Super-RENS structure offer the possibility to increase the data density by a factor of 3 to 4 in one dimension compared to a regular optical recording medium. Super-RENS structures formed of a metal oxide or a polymer compound for recording of data and a phase change layer formed of a GeSbTe or a AgInSbTe based structure for reproducing of data are known from WO 2005/081242 and US 2004/0257968, respectively. A further example of a super-RENS structure is described in WO 2004/032123. In case a semiconductor such as InSb (indium antimonide) is used for the Super-RENS structure, free charge carriers are generated in the semiconductor layer upon illumination with a reading or recording light beam. The resulting changes of the optical properties of the semiconductor are used for achieving the Super-RENS effect.

It is an object of the invention to propose an alternative design of an optical recording medium. It is a further object of the invention to propose a method and an apparatus for reading from such an optical recording medium.

According to the invention, the optical recording medium has a charge carrier generating layer, which is sandwiched between a first conductive layer and a second conductive layer. Marks are recorded in the first conductive layer or in the second conductive layer. They are detectable by monitoring a change of a voltage between the first conductive layer and the second conductive layer

A method for reading from an optical recording medium according to the invention has the steps of:
- illuminating data recorded in the first conductive layer or in the second conductive layer with a light beam;
- monitoring a change of a voltage between the first conductive layer and the second conductive layer; and
- determining a data signal from the change of the voltage.

In order to implement the invention in an apparatus for reading from an optical recording medium according to the invention, the apparatus is provided with:
- a light source for illuminating data recorded in the first conductive layer or in the second conductive layer with a light beam; and
- a monitoring circuitry for monitoring a change of a voltage between the first conductive layer (and the second conductive layer and for determining a data signal from the change of the voltage.

In contrast to known optical recording media, where only the change of the optical parameters upon irradiation is used, the proposed optical recording medium further makes use of the change of the electrical parameters upon irradiation with a light beam for readout of information. This has the advantage that no photodetector is needed for data retrieval. Of course, it is also possible to combine the data detection based on the change of the electrical parameters of the charge carrier generating layer with data readout based on detection of a reflected light beam. This leads to a more reliable data detection. In this case a photodetector is provided for detecting a light beam reflected by the optical recording medium. An evaluation circuitry then determines a data signal from the detected light beam.

Favorably, the first conductive layer and the second conductive layer are thin layers of Ag (silver) and/or indium tin oxide (ITO), which are often used as transparent contacts in electronic devices. These materials have the advantage that only a limited fraction of the energy of the illuminating light beam is absorbed or reflected by the conductive layers. In addition, there exists a lot of experience how to handle these materials.

Advantageously, the optical recording medium has a first dielectric layer below the first conductive layer and a second dielectric layer above the second conductive layer, i.e. the layer structure is as follows:

| **Layer** | **Layer type** |
|---|---|
| 1 | substrate |
| 2 | dielectric layer |
| 3 | conductive layer |
| 4 | charge carrier generating layer |
| 5 | conductive layer |
| 6 | dielectric layer |
| 7 | Cover layer |

The dielectric layers have the advantage that they facilitate the fabrication of the conductive layers, e.g. by sputtering.

For example, sputtering directly on a pure polycarbonate substrate is sometimes difficult.

Preferably, the marks or spaces are formed by holes in the conductive layer. In this way they can be easily manufactured, e.g. using known etching processes. The holes are preferably filled with material of the neighboring layer, i.e. the material of the substrate, the dielectric layer or the charge carrier generating layer. In order to retrieve the data recorded on the optical recording medium a voltage is applied to the two conductive layers. When a reading light beam enters into the charge carrier generating layer, free charge carriers are generated. These free charge carriers start to move in accordance with an electric field *E̅* applied to the conductive layers. When the reading light beam illuminates a hole in the conductive layer, there is no electric field *E̅* across the activated area. Therefore, no current flows through the activated area. In contrast, when the reading light beam does not illuminate a hole, the active zone is located between two conductors. The electric field *E̅* inside this zone forces the electrons to move. Therefore, a current flows through the activated area, which is detectable by monitoring the applied voltage.

In principle the charge carrier generating layer can constitute any of the following three elements: A photoresistor, i.e. an optoelectronic component whose resistance decreases with increasing incident light intensity; a photodiode, i.e. an optoelectronic component whose output voltage increases with increasing incident light intensity; and a phototransistor, i.e. an optoelectronic component whose current increases with increasing incident light intensity. Advantageously, the charge carrier generating layer consists of or includes cadmium selenide (CdSe), lead sulfide (PbS), lead selenide (PbSe), cadmium telluride (CdTe), tin oxide (ZnO), selen (Se), indium antimonide (InSb), indium arsenide (InAs), germanium (Ge) or silicon (Si). Of course, other semiconductor material can likewise be used.

For a better understanding the invention shall now be explained in more detail in the following description with reference to the figures. It is understood that the invention is not limited to this exemplary embodiment and that specified features can also expediently be combined and/or modified without departing from the scope of the present invention as defined in the appended claims. In the figures:
- Fig. 1: shows a known structure of an optical recording medium,
- Fig. 2: depicts a structure of an optical recording medium according to the invention,
- Fig. 3: shows a first alternative of recording marks along tracks,
- Fig. 4: shows a second alternative of recording marks along tracks,
- Fig. 5: illustrates the readout process of the optical recording medium of Fig. 2 during illumination of a space,
- Fig. 6: shows the readout process of the optical recording medium of Fig. 2 during illumination of a mark, and
- Fig. 7: depicts an apparatus for reading from an optical recording medium according to the invention.

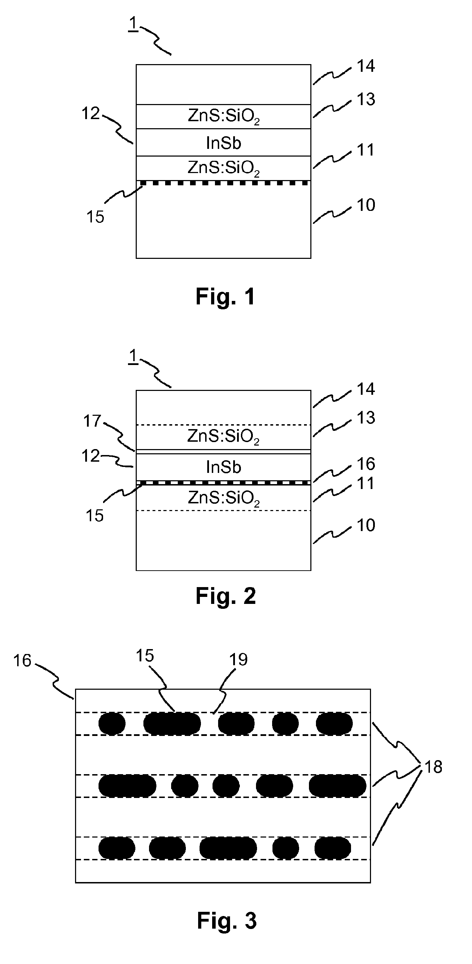

Fig. 1 shows a known structure of an optical recording medium 1 with a Super-RENS structure. Arranged above a substrate 10 is a first dielectric layer 11 made of ZnS:SiO₂. A Super-RENS layer 12, which consists of InSb, is sandwiched between this dielectric layer 11 and a second ZnS:SiO₂ dielectric layer 13.

InSb is a semiconductor, i.e. free charge carriers are generated upon illumination with a light beam. As a result the material changes both its optical and electrical parameters when it is exposed to light. The change of the optical parameters is the basis for the Super-RENS effect. A cover layer 14 is arranged on top of the second dielectric layer 13 for protection against damages or environmental influences. Data are recorded as marks (or pits) 15 (illustrated as black rectangles), which in this example are embossed into the substrate 10. Of course, this layer structure only constitutes one of a plurality of possible structures.

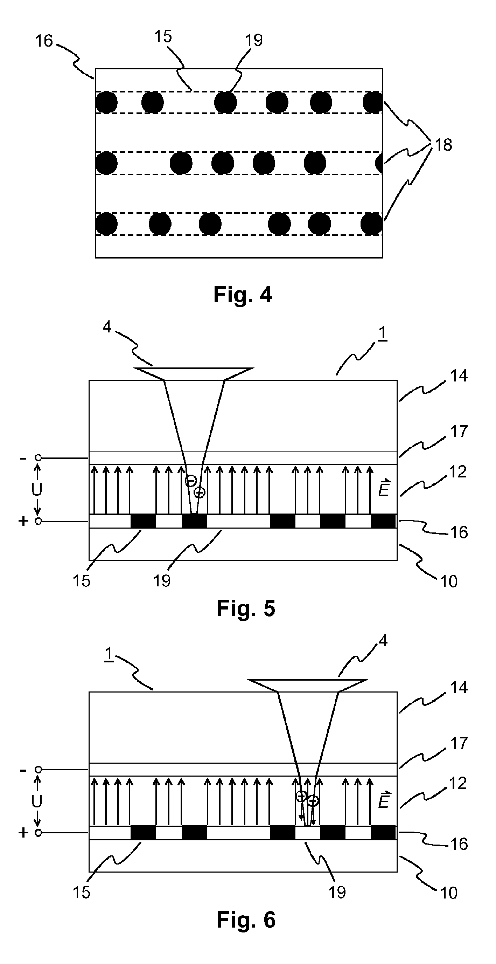

A structure of an optical recording medium 1 according to the invention is depicted in Fig. 2. The structure is rather similar to the structure of Fig. 1. However, the dielectric layers 11, 13 are replaced by two thin conductive layers 16, 17, which are fabricated by sputtering or any other suitable process. Of course, it is likewise possible to provide the two conductive layers 16, 17 in addition to the dielectric layers 11, 13. In this case the conductive layers 16, 17 are located between the dielectric layers 11, 13 and the charge carrier generating layer 12. The marks 15 are recorded in the first conductive layer 16 along tracks 18, preferably as holes in this conductive layer. This is schematically illustrated in Fig. 3. Spaces 19 are in this case formed by the conductive areas between the marks 15. Alternatively, the spaces 19 are formed as holes in the conductive layer 16, as depicted in Fig. 4. The marks 15 are then represented by the small remaining conductive areas along the tracks 18 between the spaces 19. The second conductive layer 17 is either a thin layer or a transparent layer, so that the marks 15 may be irradiated with a reading light beam 4. In the above example the marks 15 are recorded in the first conductive layer 16. It is likewise possible to record the marks 15 in the second conductive layer 17.

In contrast to known optical recording media, where only the change of the optical parameters upon irradiation is used, the proposed optical recording medium further makes use of the change of the electrical parameters for readout of information. In principle the charge carrier generating layer can constitute one of the following three elements: A photoresistor, i.e. an optoelectronic component whose resistance decreases with increasing incident light intensity; a photodiode, i.e. an optoelectronic component whose output voltage increases with increasing incident light intensity; and a phototransistor, i.e. an optoelectronic component whose current increases with increasing incident light intensity.

In order to retrieve the data recorded on the optical recording medium 1 of Fig. 2 a voltage U is applied to the two conductive layers 16, 17. A possible solution for applying the voltage to the conductive layers 16, 17 is described in K. Kojima et al.: "Investigation into Recording on Electrochromic Information Layers of Multi-Information-Layer Optical Disk Using Electrical Layer Selection", Jpn. J. Appl. Phys. 43 (2004), pp. 7058-7064. In this document ball bearings are used for voltage transfer to a multilayer disk.

An exemplary readout process is illustrated in Figs. 5 and 6. In Fig. 5 a reading light beam 4 illuminates a mark 15 of the optical recording medium 1, whereas in Fig. 6 the reading light beam 4 illuminates a space 19. The reading light beam 4 passes through the second conductive layer 17 and enters into the charge carrier generating layer 12. As the InSb of the charge carrier generating layer 12 is a semiconductor, free charge carriers (e.g. electrons) are generated due to the irradiation. These free charge carriers start to move in accordance with an electric field *E̅* (illustrated by the solid arrows) applied to the conductive layers 16, 17 with a voltage source (not shown) connected to the conductive layers 16, 17.

As can be seen in Fig. 5, when the reading light beam 4 illuminates a mark 15, which is formed as a hole in the first conductive layer 16, there is no electric field *E̅* across the activated area. Therefore, no current (or only a reduced current due to a certain electric field stemming from adjacent marks 19) flows through the activated area.

In contrast, when the reading light beam 4 illuminates a space 19, the active zone is located between two conductors. The electric field *E̅* inside this zone forces the electrons to move. Therefore, a current flows through the activated area, which is detectable by monitoring the applied voltage U. The detected current flow allows to determine a data signal from the optical recording medium 1 according to the invention, which is either used exclusively or in combination with a data signal retrieved with a photodetector 21 from a reflected reading light beam 9.

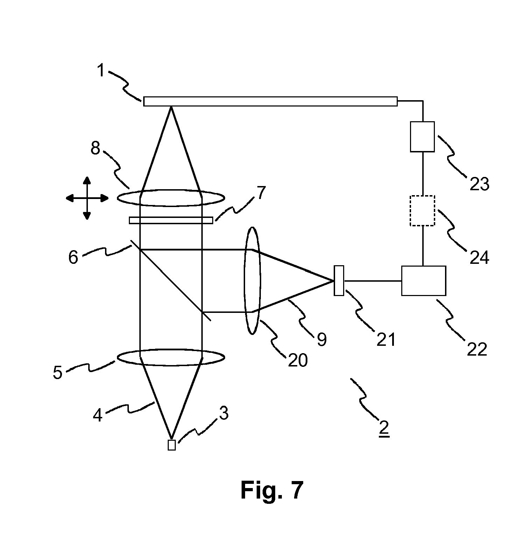

An apparatus 2 for reading from an optical recording medium 1 according to the invention is schematically depicted in Fig. 7. A laser diode 3 emits a linearly polarized reading light beam 4, which is collimated by a collimator lens 5. The collimated light beam 4 passes a polarization beam splitter 6 and a quarter wave plate 7, which transforms the light beam 4 into a circular polarized light beam 4, before it is focused onto an optical recording medium 1 by an objective lens 8. The light beam 9 reflected by the optical recording medium 1 is collimated by the objective lens 8 and passes the quarter wave plate 7, which transforms the reflected light beam 9 into a linear polarized light beam 9. Due to the quarter wave plate 7, the direction of polarization of the reflected light beam 9 is perpendicular to the direction of polarization of the initial light beam 4. The reflected light beam 9 is thus deflected by the polarization beam splitter 6 towards a focusing lens 20, which focuses the reflected light beam 9 onto a photodetector 21. The photodetector 21 usually has four detector quadrants (not shown). An evaluation circuitry 22 evaluates the signals obtained by the photodetector 21 to obtain focus and tracking signals as well as a data signal, if this is desirable. The apparatus further has a voltage source 23 for applying a voltage to the conductive layers 16, 17 of the optical recording medium. By monitoring the applied voltage with a dedicated monitoring circuitry 24 or with the evaluation circuitry 22 a data signal is obtained from the optical recording medium 1. This data signal is either used exclusively or in combination with the data signal retrieved with the photodetector 21 for retrieving data from the optical recording medium 1.

## Claims

1. Optical recording medium (1) with a charge carrier generating layer (12), **characterized in that** the charge carrier generating layer (12) is sandwiched between a first conductive layer (16) and a second conductive layer (17), wherein marks (15) are recorded in the first conductive layer (16) or in the second conductive layer (17).

2. Optical recording medium (1) according to claim 1, **further** having a first dielectric layer (11) below the first conductive layer (16) and a second dielectric layer (13) above the second conductive layer (17).

3. Optical recording medium (1) according to claim 1 or 2,
**wherein** the marks (15) or spaces (19) are formed by holes in the first conductive layer (16) or in the second conductive layer (17).

4. Optical recording medium (1) according to one of claim 1 to 3, **wherein** the charge carrier generating layer forms one of a photoresistor, a photodiode, and a phototransistor.

5. Optical recording medium (1) according to one of claim 1 to 4, **wherein** the charge carrier generating layer consists of or includes at least one of CdSe, PbS, PbSe, CdTe, ZnO, Se, InSb, InAs, Ge and Si.

6. Optical recording medium (1) according to one of claim 1 to 4, **wherein** the first conductive layer (16) and the second conductive layer (17) are thin layers of indium tin oxide and/or Ag.

7. Method for reading from an optical recording medium (1) according to one of claims 1 to 6, **having** the steps of:
- illuminating data recorded in the first conductive layer (16) or in the second conductive layer (17) with a light beam (4);
- monitoring a change of a voltage (U) between the first conductive layer (16) and the second conductive layer (17); and
- determining a data signal from the change of the voltage (U).

8. Method according to claim 7, **further** having the steps of:
- detecting a light beam (9) reflected by the optical recording medium (1); and
- determining a data signal from the detected light beam (9).

9. Apparatus for reading from an optical recording medium (1) according to one of claims 1 to 6, **having**:
- a light source (3) for illuminating data recorded in the first conductive layer (16) or in the second conductive layer (17) with a light beam (4); and
- a monitoring circuitry (24) for monitoring a change of a voltage (U) between the first conductive layer (16) and the second conductive layer (17) and for determining a data signal from the change of the voltage (U).

10. Apparatus according to claim 9, **further** having a photodetector (21) for detecting a light beam (9) reflected by the optical recording medium (1) and an evaluation circuitry (22) for determining a data signal from the detected light beam (9).
